# EUROPEAN PATENT APPLICATION

(11) **EP 1 357 385 A1**
(43) Date of publication of application: **29.10.2003**
(21) Application number: 03252623.8
(22) Date of filing: 25.04.2003
(51) Int. Cl.: G01R 3/00

(54) **Contact probe, mask and fabrication method thereof**

(30) Priority: 26.04.2002 JP 2002127053
(71) Applicant: Nihon Denshizairyo Kabushiki Kaisha, Amagasaki-shi, Hyogo 660-0805 (JP)
(72) Inventor: Mori, Chikaomi, Kumamoto-ken, 861-0527 (JP)
(74) Representative: Beresford, Keith Denis Lewis

(57) **Abstract**

A method is disclosed for producing a probe capable of keeping sure electric conduction between the probe and a conductive pad. The method comprises the steps of: applying photo resists 500 onto the front and rear faces of a conductive plate-form material 400 which is to make a probe 100; masking one face of the plate-form material 400 with a first mask 200, and masking the other face of the plate-form material 400 with a second mask 300; subjecting the photo resists 500 to exposure to light and development; and using the photo resists 500 remaining in the exposure and development the step as mask materials 510 to etch the plate-form material 400.

## Description

The present invention relates to a method for producing a probe used to measure various electric properties of a semiconductor integrated circuit as an object to be inspected, a mask for producing the probe, and a probe.

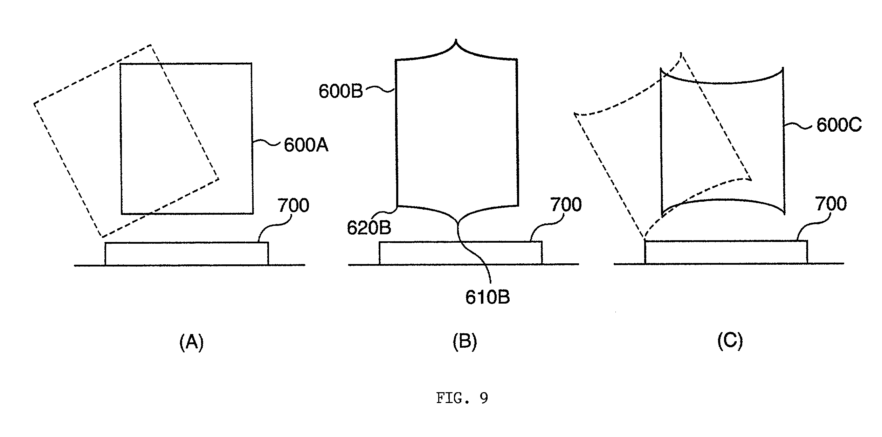

Probes in probe cards used to measure various electric properties of a semiconductor integrated circuit are classified into a type produced by sharpening the tip of a thin line made of tungsten or the like and a type produced by etching a plate-form material having electric conductivity. Figs. 9(A), 9(B) and 9(C) are schematic explanatory views for showing problems of conventional probes of this latter type.

There are known a probe wherein the tip of a contact portion 600A is flat (see Fig. 9(A)), a probe wherein the center of a contact portion 600B is projected (see Fig. 9(B)), a probe wherein the center of a contact portion 600C is hollow and edges are projected (see Fig. 9(C)), and other probes.

The above-mentioned conventional etched type probe has the following problems. First, in the case of the contact portion 600A, the tip of which is flat as illustrated in Fig. 9(A), the contact area between the portion 600A and a conductive pad 700 is large; therefore, when the contact pressure of the contact portion 600A against the conductive pad 700 is small, the contact pressure per unit area becomes low. Thus, a good connection therebetween cannot be ensured. In the case that the conductive pad 700 is fine, an alignment gap is generated when the contact portion 600A is inclined to the conductive pad 700 (see a broken line in Fig. 9(A)). As a result, they may not contact each other. In other words, when the contact portion 600A is inclined, only an edge of the contact portion 600A contacts the conductive pad 700 since the contact portion 600A is flat; however, when an alignment gap is generated, it is feared that the edge of the contact portion 600A gets out of the conductive pad 700.

Secondary, in the case of the probes wherein the center of the contact portion 600B is projected as illustrated in Fig. 9(B), it is difficult in a probe card wherein a great number of the probes are used that the heights of all the probes are made even, that is, that central projected portions 610B are positioned on the same plane. When an alien substance is sandwiched between a side edge portion 620B and the conductive pad 700, the contact portion 600B is raised away from the conductive pad 700 so that electric conduction may not be ensured.

Thirdly, in the case of the probe wherein the center of the contact portion 600C is hollow and edges are projected as illustrated in Fig. 9(C), an alignment gap is caused when the conductive pad 700 is fine and the contact portion 600C is inclined to the conductive pad 700 (see a broken line in Fig. 9(C)). As a result, they may not contact each other. That is, the number of sites in which the contact portion 600C can contact the conductive pad 700 is originally only two; therefore, when the contact portion 600C is inclined, only one site of the contact portion 600C contacts the conductive pad 700. When an alignment gap is caused at this time, it is feared that the only one site also gets out of the conductive pad 700. Moreover, an alien substance is sandwiched between the contact portion 600C and the conductive pad 700 so that electric conduction may not be ensured since only two sites are present as the sites wherein the contact portion can contact the conductive pad 700.

In light of the above-mentioned situation, the present invention has been made. An object of the present invention is to provide a method for producing a probe capable of keeping sure electric conduction between the probe and a conductive pad, a mask used in the method for producing the probe, and a probe.

The probe producing method according to the present invention is a method for producing a probe comprising a sharpened contact portion which can contact a conductive pad, which is an object to be inspected, comprising the steps of: applying photo resists onto the front and rear faces of a conductive plate-form material, which is to make the probe; masking one face of the plate-form material with a first mask, and masking the other face of the plate-form material with a second mask; subjecting the photo resists to exposure to light and development; and using the photo resists remaining in the exposure and development step as mask materials to etch the plate-form material, wherein in a first opening in the first mask and a second opening in the second mask, there is a difference in shape between their portions corresponding to the contact portion.

Moreover, the mask for producing a probe according to the present invention comprises a first mask used when a photo resist applied onto one face of a conductive plate-form material, which is to make the probe, is exposed to light and a second mask used when a photo resist applied onto the other face of the plate-form material is exposed to light, wherein in a first opening in the first mask and a second opening in the second mask, there is a difference in shape between their portions corresponding to the contact portion.

The probe according to the present invention is a probe comprising a sharpened contact portion which can contact a conductive pad, which is an object to be inspected, wherein the contact portion is hollowed from the side thereof.

A number of embodiments of the invention will now be described, by way of example only, with reference to the accompanying drawings in which:
Fig. 1 comprises views of a probe produced in a probe producing method according to an embodiment of the present invention wherein Fig. 1(A) is a schematic front view of the probe and Fig. 1(B) is a schematic side view of the probe;

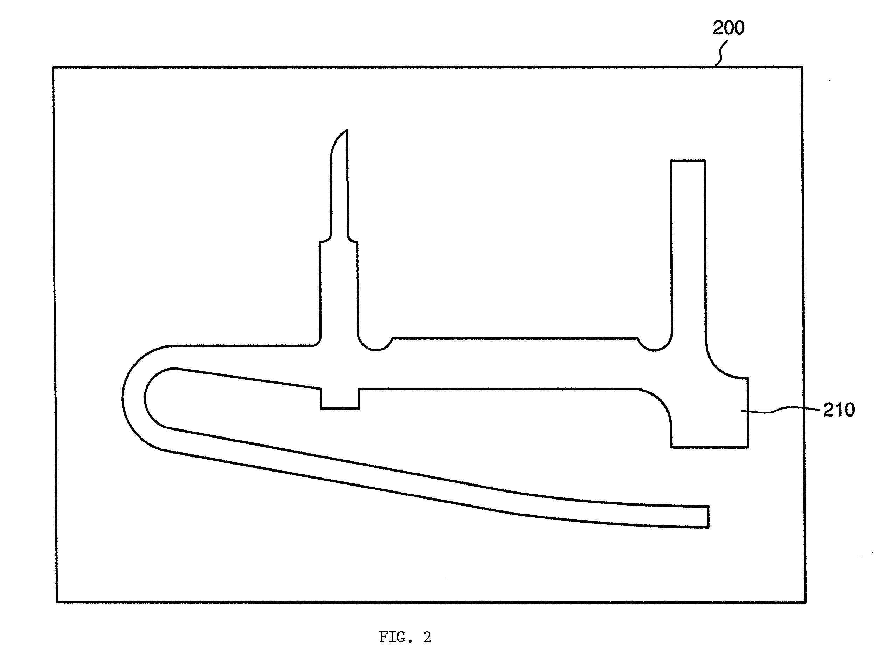

Fig. 2 is a schematic plan view of a first mask used in the probe producing method according to the embodiment of the present invention;

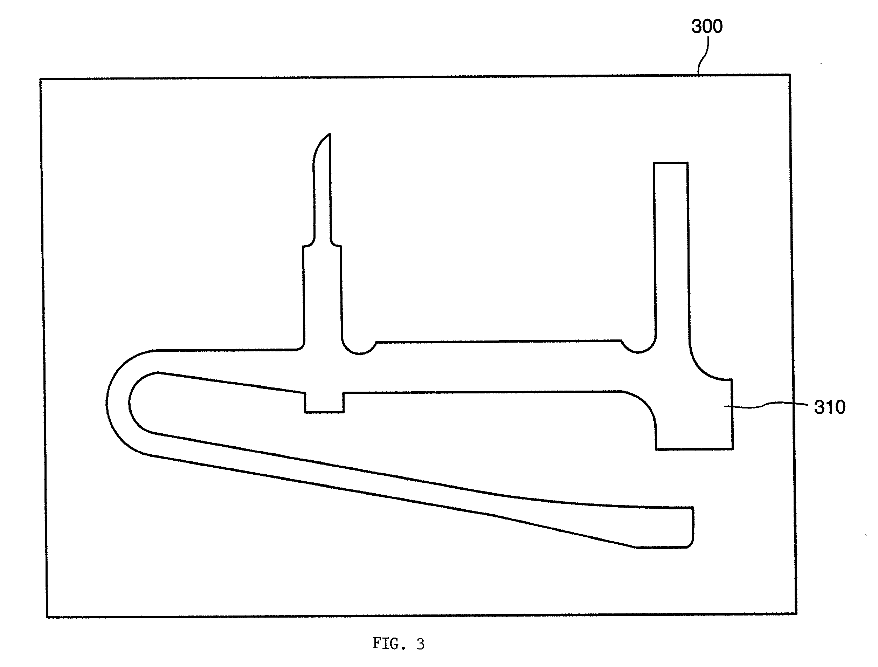

Fig. 3 is a schematic plan view of a second mask used in the probe producing method according to the embodiment of the present invention;
Fig. 4 comprises schematic explanatory views (A) to (E) illustrating steps of the probe producing method according to the first embodiment of the present invention;
Fig. 5 is a schematic explanatory view illustrating the effect of the probe produced by the probe producing method according to the embodiment of the present invention;
Fig. 6 is a schematic perspective view of another embodiment of a probe produced by the same method;
Fig. 7 comprises schematic enlarged views of the tip of another embodiment of a probe wherein Fig. 7(A) is a schematic front view thereof, Fig. 7(B) is a schematic side view thereof and Fig. 7(C) is a schematic rear view thereof;
Fig. 8 comprises schematic enlarged views of the tip of another embodiment of a probe wherein Fig. 8(A) is a schematic front view thereof, Fig. 8(B) is a schematic side view thereof, and Fig. 8(C) is a schematic rear view thereof; and
Figs. 9(A), (B) and (C) are schematic explanatory views for showing problems in conventional probes as have already been described.

In the drawings, 100 is a probe, 140 is a contact portion, 200 is a first mask, 210 is a first opening, 300 is a second mask and 310 is a second opening.

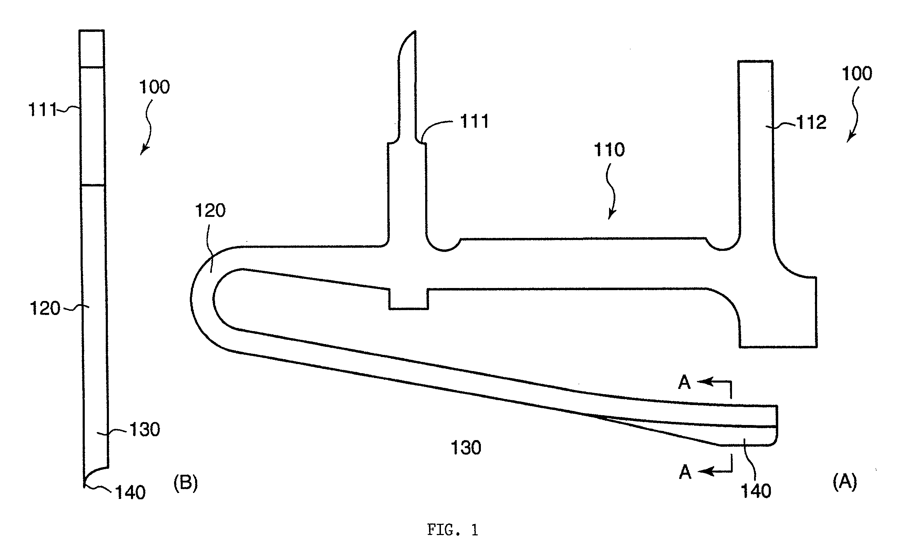

First, a probe 100 produced in the probe producing method according to an embodiment of the present invention will be described referring to Figs. 1(A) and 1(B). This probe 100 has a base portion wherein projected portions 111 and 112, which are substantially parallel to each other, are formed; a curved portion 120 curved into a substantial U-shape from an end of this base portion 110; an arm portion 130 extended from this curved portion 120; and a contact portion 140 at the tip of this arm portion 130.

The tip of the projected portion 111 is sharpened. The other projected portion 112 is formed into a straight line.

In the contact portion 140, the tip thereof is hollowed from the front side to the rear side. That is, the tip is not merely tapered from the front side to the rear side but the tip is made of a hollow curved face. This contact portion 140 is positioned just under the projected portion 112.

The curved portion 120 is a portion which warps when the contact portion 140 is brought into contact with a conductive pad of a semiconductor integrated circuit, which is an object to be measured, under pressure so as to keep a given contact pressure between the contact portion 140 and the conductive pad.

In a first mask 200 for producing this probe 100, a first opening 210 is made. This first opening 210 is an opening corresponding to portions other than the contact portion 140 of the probe 100 to be produced, that is, the base portion 110 including the projected portions 111 and 112, the curved portion 120 and the arm portion 130.

In a second mask 300, a second opening 310 is made. This second opening portion 310 is an opening corresponding to the whole including the contact portion 140 of the probe 100. Accordingly, this second opening 310 has the same shape as the probe 100 when the second opening 310 is viewed from the front.

The external form of the first mask 200 and that of the second mask 300 are set to the same size. Thus, when the front and rear faces of a plate-form material 400 having electric conductivity, which is to make the probe 100, are masked, portions except the contact portion 140 are consistent in the front and rear faces of the plate-form material 400.

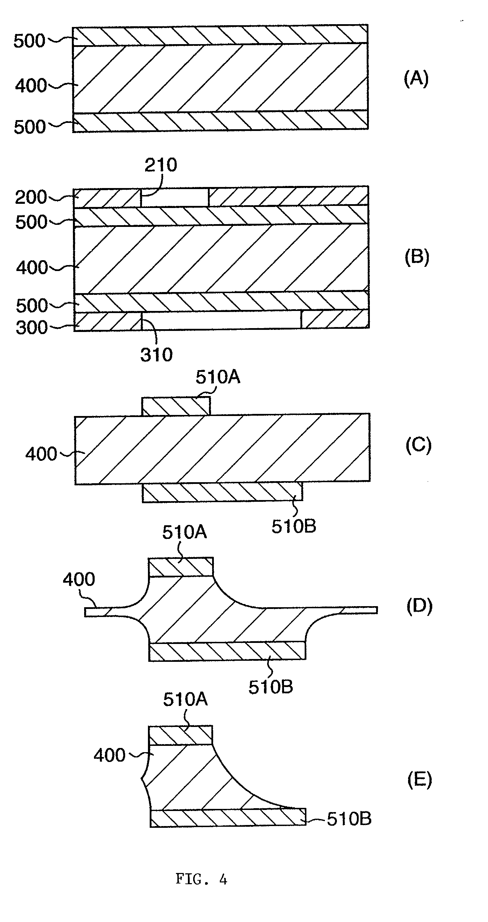

A method of using the first mask 200 and the second mask 300 to produce a probe will be described, referring to Figs. 4. In Figs. 4, the dimensions of respective members or portions are exaggeratingly drawn for the convenience of the drawing of Fig. 4.

This probe producing method has the step of applying photo resists 500 onto the front and rear faces of the plate-form material 400 having electric conductivity, which is to make the probe 100, the step of masking one of the front and rear faces of the plate-form material 400 with the first mask 200 and masking the other face with the second mask 300, the step of subjecting the photo resists 500 to exposure to light and development, and the step of using the photo resists 500 remaining in this exposure and development step as mask materials 510 to etch the plate-form material 400.

As the plate-form material 400, for example, beryllium copper, stainless steel, or the like is used. Since the thickness of this plate-form material 400 is equal to the thickness of the probe 100 to be produced, the plate-form material 400 having a thickness of 60 im is used.

The photo resists 500 are applied onto the front and rear faces by an ordinary method such as spray coating or spin coating (see Fig. 4(A)). In the same way as usual, this photo resists 500 are subjected to pre-baking or the like. As the photo resists 500, photo resists of a type in which exposed portions remain after development are used.

In the step of masking the front and rear faces of the plate-form material 400 onto which the photo resists 500 are applied with the first mask 200 and the second mask 300, portions except the contact portion 140 are made consistent in the front and rear faces of the plate-form material 400, as described above (see Fig. 4(B)).

In this state, the photo resists 500 are subjected to exposure to light and development. After the development, a mask material 510A having no portion corresponding to the contact portion 140 is formed on the face with which the first mask 200 is masked, as illustrated in Fig. 4(C). A mask material 510B having a portion corresponding to the contact portion 140 is formed on the other face with which the second mask 300 is masked. In Figs. 4, only the portion which is to make the contact portion 140 (i.e., a section taken on A-A line in Fig. 1(A) is shown.

The mask materials 510 are used to perform etching. As a result, in the mask material 510A formed through the first mask 200, the portion corresponding to the contact portion 140 is also etched, as illustrated in Fig. 4(D), since the mask material 510A has no portion corresponding to the contact portion 140. On the other hand, in the mask material 510B formed through the second mask 300, the portion corresponding to the contact portion 140 is not etched since the mask material 510B has the portion corresponding to the contact portion 140.

Since the mask material 510A formed through the first mask 200 and the mask material 510B formed through the second mask 300 have portions corresponding to the portions other than the contact portion 140, these portions are not etched.

About the portion corresponding to the contact portion 140, the one face thereof is etched but the other face thereof is not etched; therefore, the other face has the same plane as the other portions but the one face does not have the same plane as the other portion. In other words, the portion corresponding to the contact portion 140 is formed to have a smaller thickness than the other portions. Furthermore, in the case that the etching is isotropic etching, the portion corresponding to the contact portion 140 has such a shape that this portion is hollowed from the one side (see Fig. 4(E)).

When the etching is completed, the photo resists 500 remaining as the mask materials 510A and 510B are removed. As a result, the probe is completed.

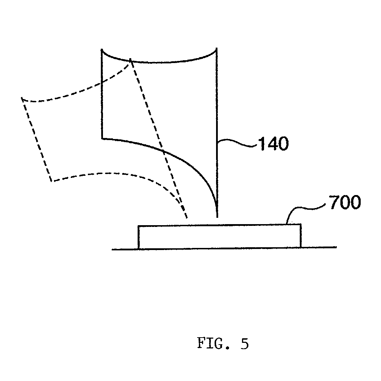

In the case that the thus-produced probe 100 contacts a conductive pad of a semiconductor integrated circuit, the contact area therebetween is small; therefore, the contact pressure per unit area is easily ensured even if the contact pressure is small. In the case that the conductive pad 700 is very small, the fear of poor conduction resulting from an alignment gap is far smaller in the probe 100 than in conventional probes even if the contact portion 140 is inclined to the conductive pad 700 (see a broken line in Fig. 5).

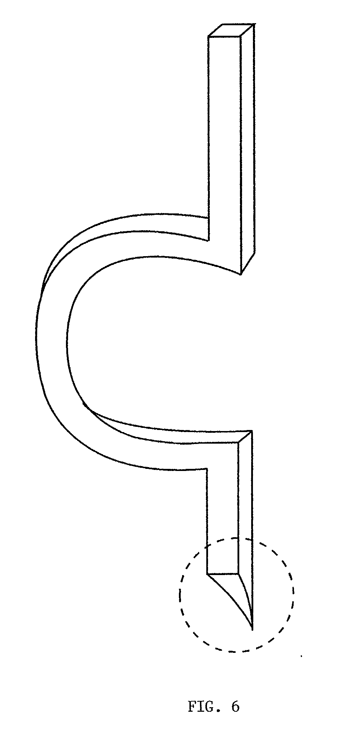

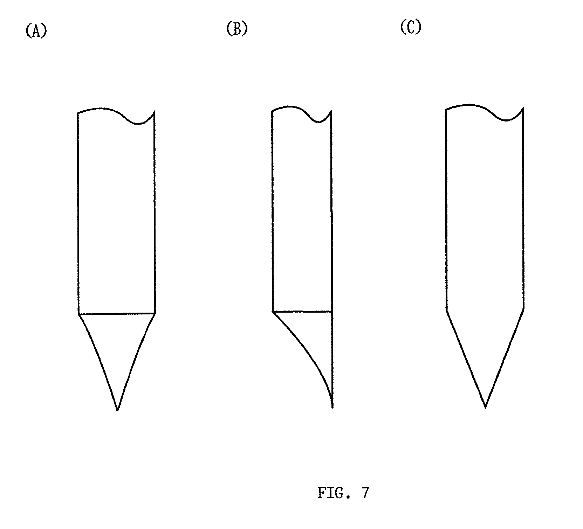

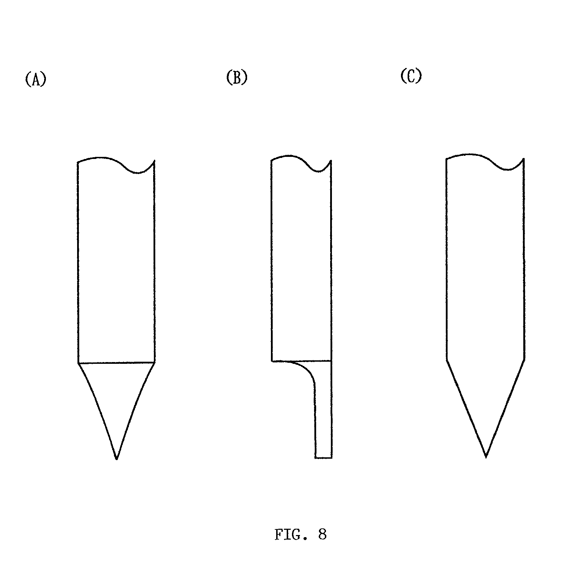

Needless to say, the probe according to the present invention is not limited to the probe 100 described as the above-mentioned embodiment, and embraces probes having other shapes. For example, the probe according to the present invention embraces probes as illustrated in Figs. 6 and 7 or 8.

The probe producing method according to an embodiment of the present invention is a method for producing a probe comprising a sharpened contact portion which can contact a conductive pad, which is an object to be inspected, comprising the steps of: applying photo resists onto the front and rear faces of a conductive plate-form material, which is to make the probe; masking one face of the plate-form material with a first mask, and masking the other face of the plate-form material with a second mask; subjecting the photo resists to exposure to light and development; and using the photo resists remaining in the exposure and development step as mask materials to etch the plate-form material, wherein in a first opening in the first mask and a second opening in the second mask, there is a difference in shape between their portions corresponding to the contact portion.

Thus, the shape difference between the portion corresponding to the contact portion in the first opening in the first mask and the portion corresponding to the contact portion in the second opening in the second mask causes a result that the front and rear faces are etched into different forms in the etching step. Therefore, the shape of the contact portion can be made into an unprecedented shape, specifically such a shape that this portion is hollowed from the side thereof. This contact portion makes it possible to ensure the contact pressure easily, as described above. Thus, the fear of poor conduction resulting from an alignment gap is very small, and a probe having a high reliability can be produced.

Moreover, the first opening is an opening for exposing portions corresponding to the portions other than the contact portion of the probe to the light, and the second opening is an opening for exposing the whole including the contact portion of the probe to the light; and in the masking step, portions corresponding to the portions other than the contact portion in the first opening in the first mask and portions corresponding to the portions other than the contact portion in the second opening in the second mask are made consistent in the front and rear faces of the plate-form material.

As a result, only the portion corresponding to the contact portion can be made different from the shape of the other portions.

The mask for producing a probe according to the present invention comprises a first mask used when a photo resist applied onto one face of a conductive plate-form material, which is to make the probe, is exposed to light and a second mask used when a photo resist applied onto the other face of the plate-form material is exposed to light, wherein in a first opening in the first mask and a second opening in the second mask, there is a difference in shape between their portions corresponding to the contact portion.

As a result, this producing mask is used to cause a result that the front and rear faces are etched into different forms in the step of etching the portion corresponding to the contact portion. Therefore, the shape of the contact portion can be made into an unprecedented shape, specifically such a shape that the portion is hollowed from the side thereof. This contact portion makes it possible to ensure the contact pressure easily, as described above. Thus, the fear of poor conduction resulting from an alignment gap is very small, and a probe having a high reliability can be produced.

Furthermore, the probe according to the present invention is a probe comprising a sharpened contact portion which can contact a conductive pad, which is an object to be inspected, wherein the contact portion is hollowed from the side thereof. According to this probe, the contact pressure is easily ensured, and the fear of poor conduction resulting from an alignment gap can be made very small.

## Claims

1. A method for producing a probe comprising a sharpened contact portion which can contact a conductive pad, which is an object to be inspected, comprising the steps of: applying photo resists onto the front and rear faces of a conductive plate-form material, which is to make the probe; masking one face of the plate-form material with a first mask, and masking the other face of the plate-form material with a second mask; subjecting the photo resists to exposure to light and development; and using the photo resists remaining in the exposure and development step as mask materials to etch the plate-form material, wherein
in a first opening in the first mask and a second opening in the second mask, there is a difference in shape between their portions corresponding to the contact portion.

2. The probe producing method according to claim 1, wherein the first opening is an opening for exposing portions corresponding to the portions other than the contact portion of the probe to the light, and the second opening is an opening for exposing the whole including the contact portion of the probe to the light; and in the masking step, portions corresponding to the portions other than the contact portion in the first opening in the first mask and portions corresponding to the portions other than the contact portion in the second opening in the second mask are made consistent in the front and rear faces of the plate-form material.

3. A mask for producing a probe, comprising a first mask used when a photo resist applied onto one face of a conductive plate-form material, which is to make the probe, is exposed to light and a second mask used when a photo resist applied onto the other face of the plate-form material is exposed to light, wherein
in a first opening in the first mask and a second opening in the second mask, there is a difference in shape between their portions corresponding to the contact portion.

4. The probe producing mask according to claim 3, wherein the first opening for exposing portions corresponding to the portions other than the contact portion of the probe to the light is made in the first mask, and the second opening for exposing the whole including the contact portion of the probe to the light is made in the second mask.

5. A probe comprising a sharpened contact portion which can contact a conductive pad, which is an object to be inspected, wherein the contact portion is hollowed from the side thereof.
